# EUROPÄISCHE PATENTSCHRIFT

(11) **EP 3 114 734 B1**
(45) Veröffentlichungstag und Bekanntmachung des Hinweises auf die Patenterteilung: **26.09.2018**
(21) Anmeldenummer: 15715126.7
(22) Anmeldetag: 04.03.2015
(51) Int. Cl.: H01R 4/48, H01R 12/53, H01R 12/57

(54) **ANSCHLUSS- ODER VERBINDUNGSKLEMME**
ELECTRICAL CONNECTOR
CONNECTEUR ÉLECTRIQUE

(30) Priorität: 06.03.2014 AT 982014 U
(43) Veröffentlichungstag der Anmeldung: 11.01.2017
(73) Patentinhaber: Tridonic GmbH & Co. KG, 6851 Dornbirn (AT)
(72) Erfinder: MOSER, Peter, A-6135 Stans (AT)
(74) Vertreter: Rupp, Christian
(86) Internationale Anmeldenummer: PCT/AT2015/050057
(87) Internationale Veröffentlichungsnummer: WO 2015/131215

(56) Entgegenhaltungen:
- EP-A1- 2 285 195
- EP-A1- 2 688 150
- EP-A2- 2 525 447
- JP-A- 2007 251 120
- US-A1- 2013 012 068

## Beschreibung

Die Erfindung betrifft eine Anschluss- oder Verbindungsklemme zur elektrischen Kontaktierung wenigstens einen Leiter mit einer Leiterplatte, insbesondere eine Leiterplatte mit zumindest einer LED, nach dem Oberbegriff des Anspruchs 1, sowie eine Leiterplatte und eine Leuchte.
Für Anwendungen mit Leuchtdioden (LEDs) werden Anschluss- oder Verbindungsklemmen mit vorzugsweise einer kleinen Bauform eingesetzt.
Die in die DE 102010014143 A1 beschriebene Anschluss- oder Verbindungsklemme zeigt eine Anschluss- bzw. Verbindungsklemme mit einem Isoliergehäuse, einen elektrischen Kontaktkörper und Kontaktschenkel, wobei die Kontaktschenkel auf einer Leiterplatte kontaktiert werden. Solche Anschluss- oder Verbindungsklemmen werden komplett auf der Vorderseite bzw. Oberseite der Leiterplatte angeordnet, d.h. auf der Seite die mit zumindest einer LED bestückt wird. Dies bringt der Nachteil, dass die Leiter und die Anschluss- oder Verbindungsklemme vom Verbraucher sichtbar sein können oder zumindest dass eine Abschattung gegeben ist.

US 2013/012068 A1 offenbart eine Anschluss- bzw. Verbindungsklemme nach dem Oberbegriff des Anspruchs 1. Aus dem Stand der Technik ist auch bekannt, dass Anschluss- oder Verbindungsklemmen durch eine Aussparung in der Leiterplatte angeordnet werden, allerdings senkrecht zu der Leiterplatte und die Leiter werden senkrecht bzw. vertikal zu der Leiterplatte in die Anschluss- oder Verbindungsklemme geführt. Dies bringt der Nachteil, dass die gesamte Bauhöhe des Systems Leiterplatte mit LED und Anschluss- oder Verbindungsklemme sehr hoch ist und nicht die Anforderungen eine gesamte niedrige Bauhöhe erfüllt.
Der Erfindung liegt die Aufgabe zugrunde, eine Anschluss- oder Verbindungsklemme so auszugestalten und so zu verbessern, dass die Anschluss- oder Verbindungsklemme selbst eine sehr geringere Bauform aufweist, vor allem mit einer sehr niedrigen Höhe, wobei die Aufbauhöhe auf der Vorder- und Rückseite der Leiterplatte mit der Anschluss- oder Verbindungsklemme minimiert wird. Eine einfache Handhabung bei Montage und Demontage des elektrischen Leiters in die Anschluss -oder Verbindungsklemme soll auch ermöglicht werden.

Die Lösung der Aufgaben erfolgt erfindungsgemäß durch die in dem unabhängigen Anspruch angegebenen Merkmale.

Die zumindest eine LED ist auf der Vorder- bzw. Oberseite der Leiterplatte angeordnet.
Die Öffnung in der Leiterplatte für die Aufnahme der Anschluss- oder Verbindungsklemme kann vorzugsweise ein Durchbruch in der Leiterplatte sein. Die Öffnung kann aber auch eine Ausnehmung, stirnseitig oder seitlich zu der Leiterplatte, sein. Sie kann auch eine Schlitzform haben.

Ein wesentliches Merkmal der Erfindung ist, dass die Anschluss- oder Verbindungsklemme im Wesentlichen waagerecht in der Öffnung der Leiterplatte anordenbar ist.

Mit dem Begriff "im Wesentlichen waagerecht" ist gemeint, dass die Anschluss- oder Verbindungsklemme in ihrer Länge betrachtet im Wesentlichen horizontal bzw. parallel zu der Öffnung der Leiterplatte liegt, wenn sie an die Leiterplatte angeschlossen wird. Zumindest eine Längsseite der Anschluss- oder Verbindungsklemme soll im Wesentlichen horizontal bzw. parallel zu der Öffnung der Leiterplatte liegen, vor allem, wenn beide Längsseiten der Anschluss- oder Verbindungsklemme nicht parallel zu einander sind, z.B. wenn beide Längsseiten mit einem Winkel von maximal 30° zueinander stehen.

Es bringt den Vorteil, dass die gesamt Bauhöhe beidseitig der Leiterplatte sehr niedrig gehalten wird. Es ist bei LED-Anwendungen gewünscht. Da die Ebene mit den Kontaktelementen oder die Längsachse des Kontaktköpers bzw. der Anschluss- oder Verbindungsklemme dadurch parallel oder zumindest im Wesentlichen parallel zu der Leiterplatte angeordnet wird, ragt die Anschluss- oder Verbindungsklemme maximal nur in ihrer Höhe aus der Leiterplatte aus, wobei die Höhe solcher Anschluss- oder Verbindungsklemmen deutlich geringer ist als ihre Länge.

Da die Verdrahtung der elektrischen Leiter auf der Rückseite der Leiterplatte erfolgt, sprich auf der Gegenseite der mit LED bestückte Seite der Leiterplatte, ist die Aufbauhöhe auf der Vorderseite bzw. LED-Seite sehr gering und nicht höher wie die LED selbst. Eine Verdrahtung auf der LED-Seite der Leiterplatte ist dadurch nicht mehr sichtbar.

Gemäß der Erfindung kann der elektrische Leiter parallel zu der Rückseite der Leiterplatte in den elektrischen Kontaktkörper der Anschluss- oder Verbindungsklemme gesteckt werden.

Für eine automatisierte Montage der elektrischen Leiter in die Anschluss- oder Verbindungsklemme ist auch vorteilhaft, wenn die elektrischen Leiter im Wesentlichen waagerecht bzw. parallel zu der Leiterplatte in die Anschluss- oder Verbindungsklemme eingeführt werden können. Es bringt auch den Vorteil, dass die Leiter in der Leuchte nicht umgeknickt werden müssen.
Es können auch weiterhin verschiedene Leiter verwendet werden, starre und/oder flexible Leiter, mit verschiedenen Durchmessern, vorzugsweise von 0,2 mm² bis 0,75 mm².

Dazu ist die herausragende Höhe der Anschluss- oder Verbindungsklemme nach der Erfindung unterhalb der Rückseite der Leiterplatte im Wesentlichen gleich oder kleiner als der Außendurchmesser des gegebenenfalls berührungsgeschützten Leitereinführungskanals. Es wird angestrebt, den Außendurchmesser des Leitereinführungskanals nicht viel größer als den Leiterquerschnitt zu gestalten.
Es wird bevorzugt, dass der zumindest ein Kontaktelement der Anschluss- oder Verbindungsklemme auf der Vorderseite der Leiterplatte gelötet werden kann. Auf der Vorderseite der Leiterplatte können an sich bekannte Leiterbahnen vorgesehen werden, wobei die Kontaktelemente auf die jeweiligen Leiterbahnen gelötet werden können.
Beispielsweise können die Kontaktelemente der Anschluss- oder Verbindungsklemme als Schenkel ausgebildet werden. Weiterhin können sie beispielsweise an den jeweiligen Enden der Anschluss- oder Verbindungsklemme, über die Längsachse der Anschluss- oder Verbindungsklemme betrachtet, angeordnet werden. Alternativ können die Kontaktelemente seitlich bzw. quer entlang der Längsachse der Anschluss- oder Verbindungsklemme angeordnet werden.
Alternativ Lösungen um die Anschluss- oder Verbindungsklemme mit der Leiterplatte anzuschließen, können aus dem Stand der Technik entnommen werden.

Die erfindungsgemäße Anschluss- oder Verbindungsklemme kann ausschließlich aus dem Kontaktkörper und den Kontaktelementen bestehen, um die Bauhöhe des Systems Anschluss- oder Verbindungsklemme mit Leiterplatte sehr gering zu halten.

Es kann auch von Vorteil sein, dass die Anschluss- oder Verbindungsklemme ein Isoliergehäuse aufweist. Es kann vorgesehen werden, dass das Isoliergehäuse nachträglich auf dem Kontaktkörper angeordnet werden kann, wobei das Isoliergehäuse beispielsweise auf dem Kontaktkörper aufschnappbar sein kann. Es kann auch vorgesehen werden, dass das Isoliergehäuse den Kontaktkörper vollständig von der Leiterplatte isoliert.

Wenn ein Isoliergehäuse bei der Anschluss- oder Verbindungsklemme vorhanden ist, kann eine bessere Leiterführung erreicht werden und ein Berührungsschutz ist gegeben.

Wenn das Isoliergehäuse den Kontaktkörper sogar vollständig von der Leiterplatte isoliert, kann die erfindungsgemäße Anschluss- oder Verbindungsklemme auch mit einer zusätzlichen Platine bzw. einem Trägerblech verwendet werden, wenn hohe Luft- und Kriechstreckenforderungen notwendig sind. Als zusätzliche Platine kann beispielsweise eine Aluminium-Platine vorgesehen werden, die auch eine bessere Wärmeableitung ermöglicht.

Als Isoliergehäuse wird ein Gehäuse aus Kunststoff bevorzugt.

Dazu kann der Kontaktkörper der Anschluss- oder Verbindungsklemme als Stanzteil ausgebildet sein. Ein Federelement kann einstückig mit dem Stanzteil ausgeführt werden, um einen Leiterklemmanschluss zu bilden. Bevorzugt wird aber ein zweiteiliges Stanzteil, wobei das Trägerteil des Stanzteils vorzugsweise aus gut leitendem Material ist, und das Federelement aus Federstahl ist. Dadurch ergibt sich Vorteilhafterweise ein leichtes Lösen der elektrischen Leiter, sowie weniger Belastung für die Kontaktelemente auf der Leiterplatte und eine Beschädigung oder Ausfall der Leiterplatte bzw. LEDs vermieden werden kann.

Als Anschluss- oder Verbindungsklemme kann auch eine an sich bekannte Anschluss- oder Verbindungsklemme genommen werden und um 180° gegenüber der an sich bekannten Montage auf der Leiterplatte eingesetzt werden. Es kann auch vorkommen, dass nur kleine Änderungen in der Herstellung einer an sich bekannte Anschluss- oder Verbindungsklemme notwendig sind, um den Einsatz nach der Erfindung zu ermöglichen, beispielsweise Änderungen bei der Ausführung der Kontaktelemente.

Es kann auch vorgesehen werden, dass der Leitereinführungskanal der Anschluss- oder Verbindungsklemme geneigt ausgeführt ist. Die Anschluss- oder Verbindungsklemme bleibt im Wesentlichen waagerecht zu der Leiterplatte, da die Neigung des Leitereinführungskanal mit einem maximalen Winkel von 30°, bevorzugt mit 10 bis 15°, erfolgen soll, ansonsten würde die Bauhöhe der Anschluss- oder Verbindungsklemme wieder zu hoch werden.

Bevorzugt wird, dass die Öffnung in der Leiterplatte gefräst ist und/oder die Größe der Öffnung in der Leiterplatte passend zu den Außenmaßen des Längsschnitts der Anschluss- oder Verbindungsklemme vorgesehen ist.

Die erfindungsgemäße Anschluss- oder Verbindungsklemme kann vorzugsweise eine schraubenlose Anschluss- oder Verbindungsklemme sein.

Die Erfindung betrifft außerdem auch eine Leiterplatte mit der erfindungsgemäßen Anschluss- oder Verbindungsklemme. Bei LED-Anwendungen werden häufig LEDs, zumindest eine LED, auf der Leiterplatte angeordnet.

Die Erfindung betrifft außerdem auch ein Leuchtsystem bzw. eine Leuchte mit der erfindungsgemäßen Anschluss- oder Verbindungsklemme.

Im Folgenden wird die Erfindung anhand Ausführungsformen näher beschrieben, die jedoch nur beispielhaft, nicht aber einschränkend aufzufassen sein sollen.

Es zeigen:
- Fig. 1a:: perspektivische Ansicht einer ersten Ausführungsform der erfindungsgemäßen Anschluss- oder Verbindungsklemme.
- Fig. 1b:: perspektivische Ansicht einer Leiterplatte mit einer ersten Ausführungsform der erfindungsgemäßen Anschluss- oder Verbindungsklemme und mit LEDs.
- Fig. 1c:: Seitenansicht der Leiterplatte nach Fig. 1b.
- Fig. 2:: perspektivische Ansicht einer Leiterplatte mit einer zweiten Ausführungsform der erfindungsgemäßen Anschluss- oder Verbindungsklemme und mit LEDs.
- Fig. 3a:: perspektivische Ansicht einer dritten Ausführungsform der erfindungsgemäßen Anschluss- oder Verbindungsklemme.
- Fig. 3b:: Seitenansicht einer Leiterplatte mit einer dritten Ausführungsform der erfindungsgemäßen Anschluss- oder Verbindungsklemme und mit LEDs.
- Fig. 4a:: Explosionsansicht der dritten Ausführungsform der erfindungsgemäßen Anschluss- oder Verbindungsklemme.
- Fig. 4b:: Explosionsansicht einer Leiterplatte mit einer zusätzlichen Platine, mit der dritten Ausführungsform der erfindungsgemäßen Anschluss- oder Verbindungsklemme und mit LEDs.
- Fig. 5a:: perspektivische Ansicht von der Vorderseite einer Leiterplatte mit einer weiteren Ausführungsform der erfindungsgemäßen Anschluss- oder Verbindungsklemme und mit LEDs.
- Fig. 5b:: perspektivische Ansicht von der Rückseite einer Leiterplatte mit der weiteren Ausführungsform der erfindungsgemäßen Anschluss- oder Verbindungsklemme aus Fig. 5a.
- Fig. 5c:: Seitenansicht einer Leiterplatte mit der weiteren Ausführungsform der erfindungsgemäßen Anschluss- oder Verbindungsklemme aus Fig. 5a.

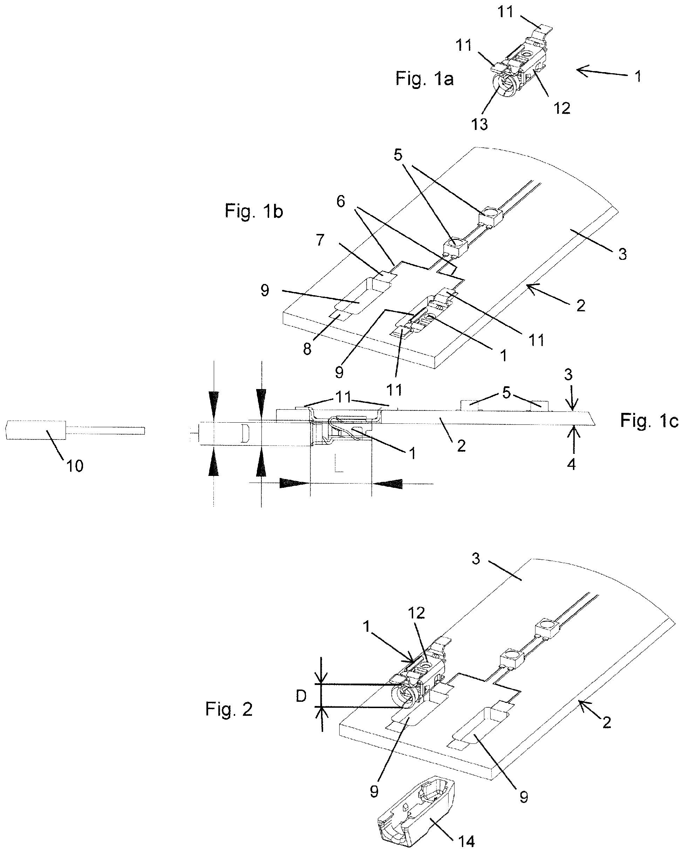

In den Fig. 1a bis Fig. 5c sind mehrere Ausführungsbeispiele einer erfindungsgemäßen Anschluss- oder Verbindungsklemme 1 dargestellt, vorteilhafterweise als schraublose Anschluss- oder Verbindungsklemme.

In Fig. 1a bis Fig. 1c ist eine erste Ausführungsform der erfindungsgemäßen Anschluss- oder Verbindungsklemme 1 gezeigt. Die Anschluss- oder Verbindungsklemme weist einen Kontaktkörper 12 auf und zwei Kontaktelemente 11, die an den jeweiligen Ende der Längsseite L der Anschluss- oder Verbindungsklemme 1 angeordnet sind. Der Kontaktkörper ist als Stanzteil ausgebildet.

Ein elektrischer Leiter 10 kann im Leitereinführungskanal 13 des Kontaktkörpers 12 wie an sich bekannt ein- und/oder ausgesteckt werden.

Die Leiterplatte 2 ist mit LEDs 5 auf ihre Vorderseite 3 bestückt. Die LEDs 5 sind über Leiterbahnen 6 mit den Kontaktbereichen 7 verbunden. Bei der Montage der Anschluss- oder Verbindungsklemme(n) 1 in der Leiterplatte, werden die Kontaktelemente 11 mit den Kontaktbereiche 7, 8 verbunden. Die Art der Verbindung kann an sich bekannt sein, z.B. können die Kontaktelemente 11 gelötet werden. Einerseits wird dadurch eine elektrische Kontaktierung mit den Kontaktbereichen 7 erzeugt, aber es wird auch eine mechanische Befestigung der Anschluss- oder Verbindungsklemme 1 mit der Leiterplatte 2, zwischen den Kontaktelementen 11 und den Kontaktbereichen 7 und 8, erreicht.

Die Anschluss- oder Verbindungsklemme 1 wird durch die gefräste Öffnung 9 in der Leiterplatte 2 montiert, so dass die Kontaktelemente 11 der Anschluss- oder Verbindungsklemme 1 auf der Vorderseite 3 der Leiterplatte 2 kommen, und der Kontaktkörper 12 nach der Montage durch die Öffnung 9 und auf der Rückseite 4 der Leiterplatte 2 sich befindet. Dadurch wird der elektrische Leiter 10 von der Rückseite 4 der Leiterplatte 2 ein- und/oder ausgesteckt.

Wenn notwendig, können mehrere Öffnungen 9 in der Leiterplatte 2 vorhanden sein, um mehrere Anschluss- oder Verbindungsklemmen 1 anordnen zu können.

Die Öffnung 9 ist in dieser Ausführungsform als Durchbruch ausgeführt. Abhängig von der Topologie der Leiterplatte 2, kann es vorkommen, dass andere Öffnungen in der Leiterplatte gemacht werden, wie z.B. stirnseitige oder seitliche Ausnehmungen, oder auch als Schlitzform.

Es ist von Vorteil, dass die Längsseite L der Anschluss- oder Verbindungsklemme 1 waagerecht bzw. parallel zu der Leiterplatte 2 steht, damit die Bauhöhe des Systems Leiterplatte 2 mit Anschluss- oder Verbindungsklemme 1 gering gehalten wird. Dazu ist die Höhe H, die aus der Leiterplatte 2 herausragt, im Wesentlichen kleiner oder gleich groß der der Außendurchmesser D des Leitereinführungsbereichs 13 der Anschluss- oder Verbindungsklemme 1. Da der Außendurchmesser D wesentlich geringer ist als die Längsseite L der Anschluss- oder Verbindungsklemme 1, ist es wichtig, die Anschluss- oder Verbindungsklemme 1 horizontal zu der Leiterplatte 2 einzusetzen, als vertikal, wie an sich bekannt auf der Rückseite einer Leiterplatte, um die gesamte Bauhöhe gering zu halten.

Weiterhin ist es wesentlich, dass der Anschluss der elektrischen Leiter 10 auf der Rückseite 4 der Leiterplatte 2 erfolgt, damit die elektrischen Leiter 10 auf der LED-Seite der Leiterplatte 2 nicht sichtbar werden.

In Fig. 2 ist eine zweite Ausführungsform der Erfindung dargestellt, wobei der Kontaktkörper 12 der Anschluss- oder Verbindungsklemme 1 nach ihrer Montage auf der Leiterplatte 2 mit einem Isoliergehäuse 14, aus einem isolierenden Material, beispielsweise aus Kunststoff, abgedeckt werden kann. Das Isoliergehäuse 14 kann beispielsweise auf dem Kontaktkörper 12 aufgeschnappt werden. Im Isoliergehäuse 14 und im Kontaktkörper 12 sind Schnappelemente bzw. die passenden Gegenstücke vorgesehen.

Damit die geringe herausragende Höhe unterhalb der Leiterplatte 2 nicht beeinträchtigt wird, soll die Materialdicke des Isoliergehäuses 14 auch gering gehalten werden.

Das Isoliergehäuse 14 bringt auch den Vorteil zusätzlich zu der Berührungssicherheit, dass eine bessere Leitereinführung gegeben ist.

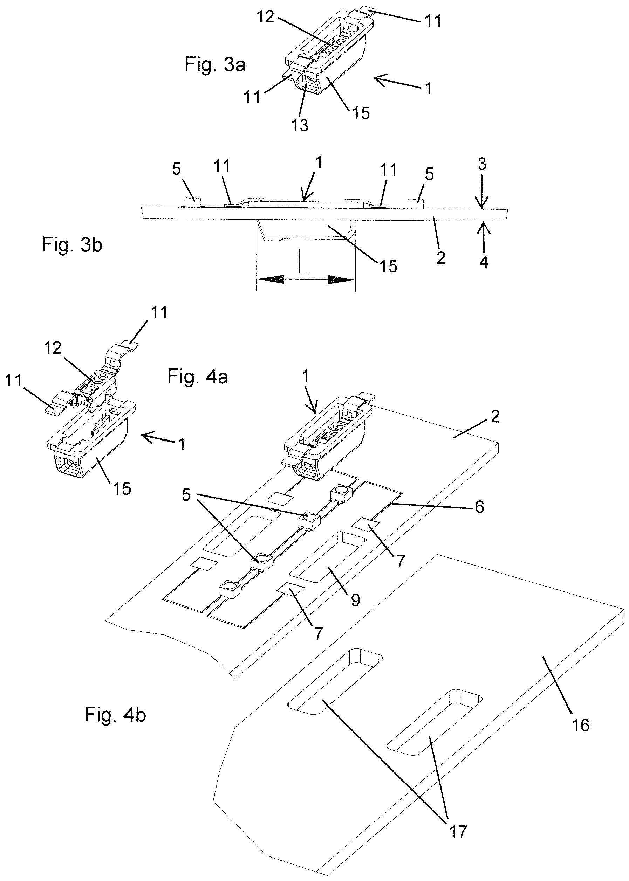

Die Fig. 3a und Fig. 3b zeigen eine weitere Variante der erfindungsgemäßen Anschluss- oder Verbindungsklemme 1, wobei das Isoliergehäuse 15 den Kontaktkörper 12 ummantelt und dadurch den Kontaktkörper 12 komplett von der Leiterplatte 2 isoliert.

Auch wenn ein Teil des Isoliergehäuses 15 auf der Vorderseite 3 der Leiterplatte 2 nach Montage der Anschluss- oder Verbindungsklemme 1 liegt, ist die Höhe auf der Vorderseite 3 der Leiterplatte 2 nicht beeinträchtigt, da dieser Teil des Isoliergehäuses 15 weniger hoch als die maximale Höhe der LEDs 5 ist. Der Leitereinführungskanal 13 bleibt in dieser Variante wiederum auf der Rückseite 4 der Leiterplatte 2.

In Fig. 4a ist eine Anschluss- oder Verbindungsklemme wie in Fig. 3a dargestellt, als Explosionsansicht.

Die Fig. 4b zeigt eine weitere Variante, wobei eine zusätzliche Platine 16 unterhalb der Leiterplatte 2 angeordnet ist. Diese zusätzliche Platine 16 weist in diesem Fall auch eine Öffnung 17, damit die Anschluss- oder Verbindungsklemme 1 durch die Öffnung 17 eingesetzt werden kann. Die Platine 16 kann beispielsweise eine Aluminum-Platine sein, die eine bessere Wärmeableitung ermöglicht. Die Platine 16 kann auch ein Trägerblech sein.

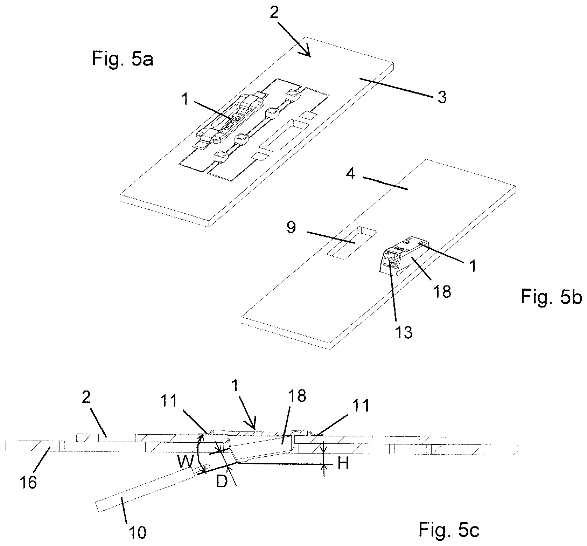

Die weitere Ausführungsform auf Fig. 5a und Fig. 5b zeigt eine Anschluss- oder Verbindungsklemme 1 mit einem geneigten Leitereinführungskanal 13. Sie weist ein Isoliergehäuse 18, wobei die untere Längsseite des Isoliergehäuses18 waagerecht bzw. parallel mit der Leiterplatte 2 steht und die andere Längsseite des Isoliergehäuses18 mit einem Winkel W zu der unteren Längsseite des Isoliergehäuses18 steht. Der Winkel W soll mit 30° begrenzt werden, ansonsten ist die gesamt Höhe der Anschluss- oder Verbindungsklemme wiederum zu hoch und würde dem Gedanken der Erfindung nicht mehr entsprechen. Bevorzugt ist eine Neigung von 10° bis 15°.

Eine solche Ausführungsform ist von Vorteil, wenn unterhalb der Leiterplatte 2 die zusätzliche Platine 16 eingesetzt wird. Dadurch ist das offene Ende des Leitereinführungskanals 13 unterhalb der zusätzlichen Platine 16 und das andere Ende des Leitereinführungskanals 13 niedriger, sogar ragt nicht aus der Platine 16 heraus. Die gesamt herausragende Höhe H unterhalb der Platine 16 ist im Wesentlichen kleiner oder gleich groß als der Außendurchmesser D des Leitereinführungskanals 13 der Anschluss- oder Verbindungsklemme 1.

Als zusätzlicher Vorteil ermöglicht eine solche Schräge des Leitereinführungskanals 13 den Einsatz von verschiedenen Blechdicken der Platine 16. Es gibt keine Stoßkante, wenn der Leiter 10 in die Anschluss- oder Verbindungsklemme lein- und ausgesteckt wird.

Weiterhin bringt dieser Ausführungsform, dass die Anschluss- oder Verbindungsklemme besser verdrahtbar ist bzw. mit einem Roboter verdrahtbar ist. Dadurch können Montagekosten reduziert werden.

Weitere nicht dargestellte Ausführungsformen sollen von der Erfindung nicht ausgeschlossen werden.

### Bezugzeichen:

- 1.: Anschluss- oder Verbindungsklemme
- 2.: Leiterplatte
- 3.: Vorderseite von 2
- 4.: Rückseite von 2
- 5.: LED
- 6.: Leiterbahn
- 7.: Kontaktbereich
- 8.: Kontaktbereich
- 9.: Öffnung
- 10.: Leiter
- 11.: Kontaktelement
- 12.: Kontaktkörper
- 13.: Leitereinführungskanal
- 14.: Isoliergehäuse
- 15.: Isoliergehäuse
- 16.: Platine
- 17.: Öffnung
- 18.: Isoliergehäuse

- D:: Außendurchmesser
- H:: Höhe
- L:: Längsseite
- W:: Winkel

## Patentansprüche

1. Anschluss- oder Verbindungsklemme (1) zur elektrischen Kontaktierung von wenigstens einem elektrischen Leiter (10) mit einer Leiterplatte (2), insbesondere eine Leiterplatte (2) mit zumindest einer LED (5),
- wobei die Anschluss- oder Verbindungsklemme (1) zumindest einen elektrischen Kontaktkörper (12) aufweist zum elektrischen Verbinden des wenigstens einen Leiters (10),
- wobei die Anschluss- oder Verbindungsklemme (1) zumindest ein Kontaktelement (11) aufweist, zur elektrischen Kontaktierung mit der Leiterplatte (2),
- wobei die Leiterplatte (2) eine Vorderseite (3), insbesondere mit zumindest einer LED (5) bestückt, und eine Rückseite (4) aufweist,
- wobei eine Öffnung (9) in der Leiterplatte (2) für die Aufnahme der Anschluss- oder Verbindungsklemme (1) vorgesehen ist,
- wobei die Anschluss- oder Verbindungsklemme (1) mit dem zumindest einen Kontaktelement (11) mittelbar oder unmittelbar auf der Vorderseite (3) der Leiterplatte (2) kontaktierbar ist,
- wobei der Anschluss des zumindest einen elektrischen Leiters (10) in dem elektrischen Kontaktkörper (12) der Anschluss- oder Verbindungsklemme (1) im Bereich der Rückseite (4) der Leiterplatte (2) vorgesehen ist,
**dadurch gekennzeichnet, dass**
die Anschluss- oder Verbindungsklemme (1) im Wesentlichen waagerecht in der Öffnung (9) der Leiterplatte (2) anordenbar ist,
der elektrische Kontaktkörper (12) einen Leitereinführungskanal (13) aufweist und
die herausragende Höhe (H) der Anschluss- oder Verbindungsklemme (1) unterhalb der Rückseite (4) der Leiterplatte (1) im Wesentlichen gleich oder kleiner ist als der Außendurchmesser (D) des gegebenenfalls berührungsgeschützten Leitereinführungskanals (13).

2. Anschluss- oder Verbindungsklemme (1) nach dem Anspruch 1,
**dadurch gekennzeichnet, dass**
der elektrische Leiter (10) parallel zu der Rückseite (4) der Leiterplatte (2) in den elektrischen Kontaktkörper (12) der Anschluss- oder Verbindungsklemme steckbar ist.

3. Anschluss- oder Verbindungsklemme (1) nach einem der vorhergehenden Ansprüche,
**dadurch gekennzeichnet, dass**
der zumindest ein Kontaktelement (11) der Anschluss- oder Verbindungsklemme (1) auf der Vorderseite (3) der Leiterplatte (2) gelötet ist.

4. Anschluss- oder Verbindungsklemme (1) nach einem der vorhergehenden Ansprüche,
**dadurch gekennzeichnet, dass**
die Anschluss- oder Verbindungsklemme (1) ein Isoliergehäuse (14, 15, 18) aufweist, wobei das Isoliergehäuse (14) nachträglich auf dem Kontaktkörper (12) angeordnet werden kann und/oder wobei das Isoliergehäuse (15, 18) den Kontaktkörper (12) vollständig von der Leiterplatte (2) isoliert.

5. Anschluss- oder Verbindungsklemme (1) nach einem der vorhergehenden Ansprüche,
**dadurch gekennzeichnet, dass**
der Kontaktkörper (12) der Anschluss- oder Verbindungsklemme (1) als Stanzteil ausgebildet ist und/oder ein Federelement aufweist.

6. Anschluss- oder Verbindungsklemme (1) nach einem der vorhergehenden Ansprüche,
**dadurch gekennzeichnet, dass**
der Leitereinführungskanal (13) der Anschluss- oder Verbindungsklemme (1) geneigt ausgeführt ist.

7. Anschluss- oder Verbindungsklemme (1) nach einem der vorhergehenden Ansprüche,
**dadurch gekennzeichnet, dass**
die Öffnung (9) in der Leiterplatte (2) gefräst ist und/oder die Größe de Öffnung (9) in der Leiterplatte (2) passend zu den Außenmaßen des Längsschnitts der Anschluss- oder Verbindungsklemme (1) vorgesehen ist.

8. Leiterplatte (2), insbesondere mit zumindest einer LED, mit einer Anschluss- oder Verbindungsklemme (1) nach einem der vorhergehenden Ansprüche.

9. Leuchtsystem mit einer Anschluss- oder Verbindungsklemme (1) nach einem der vorhergehenden Ansprüche.

## Claims

1. A terminal clamp or connection clamp (1) for electrically contacting at least one electrical conductor (10) with a circuit board (2), in particular a circuit board (2) with at least one LED (5),
- wherein the terminal clamp or connection clamp (1) has at least one electrical contact body (12) for the electrical connection of at least one conductor (10),
- wherein the terminal clamp or connection clamp (1) has at least one contact element (11) for electrically contacting the circuit board (2),
- wherein the circuit board (2) has a front side (3), in particular fitted with at least one LED (5), and a rear side (4),
- wherein an opening (9) is provided in the circuit board (2) for receiving the terminal clamp or connection clamp (1),
- wherein the terminal clamp or connection clamp (1) can be indirectly or directly contacted with at least one contact element (11) on the front side (3) of the circuit board (2),
- wherein the connection of the least one electrical conductor (10) is provided in the electrical contact body (12) of the terminal clamp or connection clamp (1) in the region of the rear side (4) of the circuit board (2),
**characterized in that**
the terminal clamp or connection clamp (1) can be arranged essentially horizontally in the opening (9) of the circuit board (2),
the electrical contact body (12) has a conductor insertion channel (13) and the projecting height (H) of the terminal clamp or connection clamp (1) underneath the rear side (4) of the circuit board (1) is essentially equal to or less than the outer diameter (D) of the optionally contact-protected conductor insertion channel (13).

2. A terminal clamp or connection clamp (1) according to Claim 1,
**characterized in that**
the electrical conductor (10) can be inserted into the electrical contact body (12) of the terminal clamp or connection clamp parallel to the rear side (4) of the circuit board (2).

3. A terminal clamp or connection clamp (1) according to any one of the preceding claims,
**characterized in that**
the at least one contact element (11) of the terminal clamp or connection clamp (1) is soldered on the front side (3) of the circuit board (2).

4. A terminal clamp or connection clamp (1) according to any one of the preceding claims,
**characterized in that**
the terminal clamp or connection clamp (1) has an insulating housing (14, 15, 18), wherein the insulating housing (14) can be arranged subsequently on the contact body (12) and/or wherein the insulating housing (15, 18) completely insulates the contact body (12) from the circuit board (2).

5. A terminal clamp or connection clamp (1) according to any one of the preceding claims,
**characterized in that**
the contact body (12) of the terminal clamp or connection clamp (1) is designed as a stamped part and/or has a spring element.

6. A terminal clamp or connection clamp (1) according to any one of the preceding claims,
**characterized in that**
the conductor insertion channel (13) of the terminal clamp or connection clamp (1) is designed such that it is inclined.

7. A terminal clamp or connection clamp (1) according to any one of the preceding claims,
**characterized in that**
the opening (9) in the circuit board (2) is milled and/or the size of the opening (9) in the circuit board (2) is provided to match the external dimensions of the longitudinal section of the terminal clamp or connection clamp (1).

8. A circuit board (2), in particular with at least one LED, with a terminal clamp or connection clamp (1) according to any one of the preceding claims.

9. A lighting system with a terminal clamp or connection clamp (1) according to any one of the preceding claims.

## Revendications

1. Borne de raccordement ou de connexion (1) pour la mise en contact électrique d'au moins un conducteur électrique (10) avec un circuit imprimé (2), plus particulièrement un circuit imprimé (2) avec au moins une LED (5),
- la borne de raccordement ou de connexion (1) comprenant au moins un corps de contact électrique (12) pour la connexion électrique de l'au moins un conducteur (10),
- la borne de raccordement ou de connexion (1) comprenant au moins un élément de contact (11) pour le contact électrique avec le circuit imprimé (2),
- le circuit imprimé (2) comprenant un côté avant (3), plus particulièrement équipé d'au moins une LED (5), et un côté arrière (4),
- une ouverture (9) dans le circuit imprimé (2) étant prévue pour le logement de la borne de raccordement ou de connexion (1),
- la borne de raccordement ou de connexion (1) pouvant être mise en contact avec l'au moins un élément de contact (11) de manière indirecte ou directe sur le côté avant (3) du circuit imprimé (2),
- le raccordement de l'au moins un conducteur électrique (10) dans le corps de contact (12) de la borne de raccordement ou de connexion (1) étant prévu au niveau du côté arrière (4) du circuit imprimé (2),
**caractérisée en ce que**
la borne de raccordement ou de connexion (1) peut être disposée de manière globalement horizontale dans l'ouverture (9) du circuit imprimé (2),
le corps de contact électrique (12) comprend un canal d'insertion de conducteur (13) et
la hauteur dépassante (H) de la borne de raccordement ou de connexion (1) en dessous du côté arrière (4) du circuit imprimé (1) est globalement inférieure ou égale au diamètre extérieur (D) du canal d'insertion de conducteur (13), le cas échéant protégé contre un contact.

2. Borne de raccordement ou de connexion (1) selon la revendication 1,
**caractérisée en ce que**
le conducteur électrique (10) peut être enfiché parallèlement au côté arrière (4) du circuit imprimé (2) dans le corps de contact électrique (12) de la borne de raccordement ou de connexion.

3. Borne de raccordement ou de connexion (1) selon l'une des revendications précédentes,
**caractérisée en ce que**
l'au moins un élément de contact (11) de la borne de raccordement ou de connexion (1) est soudé le côté avant (3) du circuit imprimé (2).

4. Borne de raccordement ou de connexion (1) selon l'une des revendications précédentes,
**caractérisée en ce que**
la borne de raccordement ou de connexion (1) comprend un boîtier isolant (14, 15, 18), le boîtier isolant (14) pouvant être disposé ultérieurement sur le corps de contact (12) et/ou le boîtier isolant (15, 18) isolant entièrement le corps de contact du circuit imprimé (2).

5. Borne de raccordement ou de connexion (1) selon l'une des revendications précédentes,
**caractérisée en ce que**
le corps de contact (12) de la borne de raccordement ou de connexion (1) est conçue comme une pièce estampée et/ou comprend un élément à ressort.

6. Borne de raccordement ou de connexion (1) selon l'une des revendications précédentes,
**caractérisée en ce que**
le canal d'insertion de conducteur (13) de la borne de raccordement ou de connexion (1) est conçue de manière inclinée.

7. Borne de raccordement ou de connexion (1) selon l'une des revendications précédentes,
**caractérisée en ce que**
l'ouverture (9) dans le circuit imprimé (2) est fraisée et/ou la taille de l'ouverture (9) dans le circuit imprimé (2) est adaptée aux dimensions extérieures de la coupe longitudinale de la borne de raccordement ou de connexion (1).

8. Circuit imprimé (2), plus particulièrement avec au moins une LED, avec une borne de raccordement ou de connexion (1) selon l'une des revendications précédentes.

9. Système d'éclairage avec une borne de raccordement ou de connexion (1) selon l'une des revendications précédentes.
